Europäisches Patentamt

(19) European Patent Office

Office européen des brevets

(11) Publication number: **0 335 310**
**A2**

## (12) EUROPEAN PATENT APPLICATION

(21) Application number: **89105418.1**

(22) Date of filing: **28.03.89**

(51) Int. Cl.4: **C03C 17/245 , C23C 16/40 , H01L 39/24**

(30) Priority: **01.04.88 US 176562**

(43) Date of publication of application:
**04.10.89 Bulletin 89/40**

(84) Designated Contracting States:
**DE ES FR GB IT**

(71) Applicant: **PPG INDUSTRIES, INC.**
**One PPG Place**
**Pittsburgh Pennsylvania 15272(US)**

(72) Inventor: **Breininger, Josephine Shannon**
**70 Lebanon Hills Drive**
**Pittsburgh, Pa. 15228(US)**

(74) Representative: **Sternagel, Hans-Günther, Dr. et al**
**Patentanwälte Dr. Michael Hann Dr. H.-G.**
**Sternagel Sander Aue 30**
**D-5060 Bergisch Gladbach 2(DE)**

(54) Formation of superconducting metal oxide film by pyrolysis.

(57) A metal oxide coating composition and method for its pyrolytic deposition are disclosed whereby a mixture of metal-containing coating reactants applied to a glass surface at a temperature sufficient to thermally decompose to form a film of metal oxides wherein the metals are selected and proportioned to yield a film having the composition of a superconducting material. The coated article may be annealed in a controlled manner to strengthen the substrate and/or optimize superconducting properties of the film.

EP 0 335 310 A2

## FORMATION OF SUPERCONDUCTING METAL OXIDE FILM BY PYROLYSIS

### Field of the Invention

The present invention relates generally to the art of superconducting ceramic oxides, and more particularly, to the art of chemical polymerization processes for producing ceramic oxides.

### Background of the Invention

Transition metal alloys such as NbTi, $Nb_3X$ and $V_3X$, wherein X is a non-transition-metal element such as tin, silicon or germanium, having an A15 crystal structure were known to exhibit superconductivity at temperatures of 17 to 23K. Metal oxides such as $LiTi_2O_4$ and $BaPb_{1-x}Bi_xO_3$, wherein x is optimally 0.25, were found to exhibit superconductivity at temperatures of around 13K. A composition of $Ba_xLa_{5-x}Cu_5O_{5(3-y)}$ annealed near 900°C under reducing conditions showed features associated with superconductivity near 30K. This Ba-La-Cu-O system comprised several phases, the superconducting one being identified as $Ba_xLa_{2-x}CuO_{4-y}$, a phase with a tetragonal structure. A single phase composition wherein x = 0.15 exhibited conductivity at 23K. By substituting strontium for barium in such compositions, superconductivity has been observed at temperatures up to 52K. By substituting yttrium for lanthanum, conductivity has been observed at temperatures of 80K and as high as 95K. The Y-Ba-Cu-O system comprised two phases, a green semiconducting phase and a black superconducting phase identified as $YBa_2Cu_3O_{9-y}$, an oxygen-deficient perovskite wherein y represents the oxygen deficiency and is optimally about 2.1.

This class of compounds may be addressed as $RBa_2Cu_3O_{9-y}$ wherein R may be a transition metal or rare earth ion such as scandium, lanthanum, neodymium, sanarium, europium, gadolinium, dysprosium, trolmium, erbium, ytterbium and lutetium. Such compositions have been reportedly synthesized by conventional ceramic technique. Metal oxide or carbonate powders of the required metals are thoroughly mixed in appropriate ratios and heated for several hours to allow solid-state reaction. The mixture is then cooled, ground, pelletized and sintered at 900 to 1100°C to yield a single phase composition of the desired proportions. For example, powders of $La_2O_3$, $BaO_2$, CuO, $BaCO_3$, $SrCO_3$, and $CaCO_3$ have been mixed, calcined, pulverized, pelletized and sintered to form such well-known superconducting compositions as $La_{1.85}Sr_{0.15}CuO_{4-y}$, $Y_{1.2}Ba_{0.8}CuO_{4-y}$ and $YBa_2Cu_3O_{9-y}$. Superconductivity depends heavily on the relative proportions of the metals. Further, superconductivity depends critically on the oxygen deficiency factor y which is determined by the temperature and atmosphere in which the powders are sintered, as well as on the cooling rate, and which is extremely difficult to control. In these conventional ceramic oxide forming processes, the heating necessary to attain a homogeneous composition can be detrimental to superconductivity by promoting grain growth and phase separation.

U.S. Patent Application Serial No. 50,824 filed May 15, 1987, by B. E. Yoldas provides equivalent superconducting ceramic compositions by chemical polymerization processes from organometallic reactants at ambient temperatures. These "sol-gel" processes allow better control of composition stoichiometry, which is critical for superconducting materials, and also allow monitoring of the oxidation state of copper. Sol-gel processes also permit formation of superconductive mixed metal oxide composition precursors which are coatable in a liquid state, formable in a thermoplastic polymeric state, and can be impregnated into a porous matrix. The chemical polymerization process allows for the existence of stable nonequilibrium states, as well as modification of the coordination and valence states of the metal components, by eliminating the high temperature consolidation reactions of conventional ceramic processes.

In Applied Physics Letters, Volume 2, pages 163-165, Guptor et al disclose $Y_1Ba_2Cu_3O_{7-8}$ thin films grown by a simple spray deposition technique. The preparation of such films on single crystals of MgO, yttria stabilized zirconia or $SrTiO_3$ involves spraying a stoichiometric solution of the nitrate precursors on the substrate at 180°C, prebaking the sprayed film in air for 20 minutes at 500°C, and annealing the film under flowing $O_2$ in an oven at 900 to 950°C followed by cooling to 200°C in about 3 hours.

### Summary of the Invention

The present invention involves depositing thin films of metal oxides having the compositions of known superconducting materials by pyrolysis of coating reactants on a hot glass substrate. The coating reactants may be in solution, either organic, such as acetylacetonates in chlorinated solvents, or inorganic, such as chlorides or acetates in aqueous solution Coating solutions may be applied by spraying, or may be vaporized for chemical vapor deposition. Solvent-free coating compositions may be applied by chemical vapor deposition as well.

## Description of the Preferred Embodiments

The present invention involves combining organometallic coating reactants containing metals such as barium, lead, yttrium, bismuth, scandium, lanthanum, strontium, copper and other transition or rare earth metals in appropriate proportions in a suitable medium for delivery to a hot glass surface whereupon the coating reactants thermally decompose to form a mixed metal oxide film having the composition of a known superconducting material such as $LaSr_2Cu_3O_{9-y}$ and $YBa_2Cu_3O_{9-y}$, wherein y is between about 1.8 and 2.5. The coating reactants may be dissolved in a solvent, dispersed or suspended in a fluid, or vaporized.

Preferably, a mixture of coating reactants is in solution. Preferred organic solutions comprise a mixture of metal acetyl-acetonates in chlorinated solvents such as those described in U.S. Patent No. 3,660,061 to Donley et al, the disclosure of which is incorporated herein by reference. Inorganic metal salts such as chlorides in aqueous solution may also be used.

In an alternative embodiment, relatively insoluble coating reactants may be used in either physical or chemical suspension in liquid media as described in U.S. Patent Nos. 4,719,126 and 4,719,127, the disclosures of which are incorporated herein by reference.

In another embodiment of the invention, coating reactants which can be vaporized without significant decomposition may be applied in vapor form with or without a carrier fluid to produce coatings by chemical vapor deposition as described in U.S. Patent Nos. 3,852,098 and 4,401,695.

While the coating process of the present invention may be carried out using individual glass sheets heated to appropriate temperatures, it is preferably performed to coat a continuous float glass ribbon which is still at an elevated temperature from the forming process. The temperature of the glass at the point where a coating is applied is preferably in the range of 1000 to 1250° F (about 538 to 677° C). The desired temperature of the substrate will determine the position on the float line where the coating process takes place. After the coating is applied, the coated glass may be conducted through an annealing lehr to strengthen the glass and to optimize the superconducting properties of the film.

The above-described invention will be further understood from the descriptions of specific examples which follow.

### EXAMPLE

Coating solutions of acetylacetonate reactants are prepared in organic solvents as follows. A solvent system is prepared comprising 25 volume percent methanol and 75 volume percent methylene chloride. Into 1000 milliliters of the solvent are dissolved 5.8 grams of barium acetylacetonate, then 2.5 grams of yttrium acetylacetonate and finally 6.8 grams of copper acetylacetonate. Clear float glass samples measuring 2 x 4 x 7/32 inch (about 5.1 x 10.2 x 0.56 centimeter) are heated in a furnace set at 1200° F (about 649° C) for 6 minutes. The heated glass samples are removed from the furnace, and one surface is sprayed in air with the above-described solution. A uniform transparent film is formed. The coated glass may be reheated and resprayed to develop thicker films, the film thickness determining its optical properties.

The above example is offered to illustrate the present invention. Other organic compounds of these and other metals may be pyrolytically deposited to form metal oxide films of any superconductor composition. The scope of the present invention is defined by the following claims.

## Claims

1. A method for producing a thin film of metal oxides having the composition of superconducting materials comprising the steps of:
   a. maintaining a substrate at a temperature sufficient to pyrolyze metal-containing coating reactants to metal oxides;
   b. applying to a surface of said substrate a coating composition comprising a mixture of metal-containing coating reactants in proper proportion to form a metal oxide film having the composition of superconducting material; and
   c. thermally decomposing said mixture of metal-containing coating reactants to deposit on said surface of said substrate a film having the composition of a superconducting material.

2. A method according to claim 1, wherein said mixture of metal-containing coating reactants comprises a mixture of compounds of metals selected from the group consisting of lanthanum, strontium, yttrium, barium, copper, bismuth, lead and scandium.

3. A method according to claim 1, wherein said mixture of metal-containing coating reactants comprises a mixture of lanthanum, strontium and copper compounds.

4. A method according to claim 1, wherein said mixture of metal-containing coating reactants comprises a mixture of yttrium, barium and copper compounds.

5. A method according to claim 1, wherein said metal-containing coating reactants are applied in solution.

6. A method according to claim 1, wherein said metal-containing coating reactants are applied in the vapor state.

7. A method according to claim 1, further comprising the step of annealing the substrate having said film thereon.

8. A method according to claim 6, wherein said substrate is glass.

9. A coated article comprising:

a. A glass substrate; and

b. deposited on a surface of said substrate a metal oxide film comprising the thermal decomposition productions of a mixture of metal-containing coating reactants wherein the metals are selected and present in proper rates to yield a coating having the composition of a material.

10. A coated article according to claim 9, wherein said metal-containing coating reactants comprise metals selected from the group consisting of yttrium, barium, bismuth, lead, lanthanum, strontium, scandium, copper and mixtures thereof.

11. A coated article according to claim 10, wherein said metal-containing coating reactants comprise a mixture of lanthanum, strontium and copper compounds.

12. A coated article according to claim 10, wherein said metal-containing coating reactants comprise a mixture of yttrium, barium and copper compounds.